# EUROPEAN PATENT APPLICATION

(11) **EP 3 157 310 A1**
(43) Date of publication of application: **19.04.2017**
(21) Application number: 15189309.6
(22) Date of filing: 12.10.2015
(51) Int. Cl.: H05K 3/00

(54) **AN ENTRY SHEET FOR PERFORATING ELECTRIC BOARDS SUCH AS PRINTED CIRCUIT BOARDS**

(71) Applicant: AGFA GRAPHICS NV, 2640 Mortsel (BE)
(72) Inventor: Lenaerts, Jens, 2640 Mortsel (BE); Boulonne, Michel, 2640 Mortsel (BE)
(74) Representative: Vanderstede, Els

(57) **Abstract**

The invention relates to an entry sheet comprising an aluminium substrate and a coating including 70%wt to 92%wt polyvinyl alcohol. The coating lubricates drilling and reduces effectively needle breakage during drilling an electric board and effectively enhances the accuracy of drilling.

## Description

### FIELD OF THE INVENTION

The present invention relates to entry sheets used for making perforations in electric boards, e. g. for making through-holes in printed circuit boards.

### BACKGROUND OF THE INVENTION

In the technical field of electronic technology, there is a continuous trend in developing electronic products which are both of low weight and small in size. An electronic product typically contains a main board which includes many electronic elements which are supported and/or connected by one or more circuit board(s). The most common circuit board at present is the printed circuit board (PCB).

A printed circuit board connects electronic parts with one another to exert their integral function and hence is an essential part of all electronic information products. A printed circuit board is a flat plate made of a non-conductive material. This plate is usually provided with pre-drilled holes for installing chips and other electronic elements which facilitate electronical connections pre-defined on the surface of the board.

Conventionally, when perforating a so-called through-hole in a printed circuit board, a plurality of printed circuit boards are stacked on a back-up board and a support board - also referred to herein as an *entry sheet-* is placed on the upper surface of the uppermost board. In this state, perforation processing of the printed circuit boards is executed by making a drill penetrate the support board from above to form through-holes in all of the stacked boards at one time. The entry board is used for improving for example the biting of the drill and preventing occurrence of damages on the board's surface and/or generation of burrs at the periphery of the perforation at the time of perforating.

EP 1 187 516 discloses an entry sheet for making holes in PCB's which improves the quality and productivity of the perforation of the PCB by reducing frictional heat and improving the location accuracy. US 4,781,495 and US 4,929,370 disclose a method of drilling a hole in a PCB which is provided with a paper sheet impregnated with a water-soluble lubricant such as synthetic wax - for example glycols such as diethylene glycol or dipropylene glycol and fatty acids - and a non ionic surfactant. However, this method insufficiently prevents the generation of heat of the drill and the impregnation of the porous paper is often poor resulting in a sticky sheet. JP A 4-92494 and JP A 6-344297 attemp to solve these problems by providing a hole-making method using a lubricant mixture composed of polyethylene glycol or polyether ester and a water-soluble lubricant.

By applying on top of the electric board(s) an entry sheet comprising an aluminium foil coated with a lubricant layer, it has been observed that due to the wetting and/or buffering effect of the layer on the one hand and the heat-dissipating ability of the aluminium foil on the other hand, the quality of the holes is improved and needle breakage and occurrence of stickiness are reduced. However, depending on the thickness of the lubricant layer the entry sheets may heavily warp resulting in a poor workability. Indeed, in order to obtain sufficient bonding between the lubricant layer and the metal foil, the sheet is generally produced at a temperature at which the sheet is softened. Due to thermal shrinkage, the sheet tends to warp which results in low productivity and/or workability. Alternatively, in order to improve the adhesion between the surface of the aluminium substrate and the lubrication layer, the surface of the aluminium substrate may be subjected to a surface treatment such as for example a primer treatment or precoat treatment. This is a cumbersome and time consuming process.

A further major problem in preparation of entry sheets is that the application of the water-soluble lubricant layer on the aluminium substrate is difficult due to poor film formation of the components in the layer. In addition, the layer may become sticky which makes handling of the entry sheet difficult. Not only the hands of the operators become sticky, but when stored in a stacked manner, the adjacent boards adhere with each other, which requires a time-consuming one by one detaching of the support boards at the time of use. This may cause partial detaching of the lubricant layer from adjacent support boards resulting in an uneven thickness and an irregular surface of the lubrication layer which in turn results in breakage of drills and/or deteriorated positioning accuracy of perforation processing. Also, in the case of storing entry sheets in a wound manner, the adjacent entry sheets may adhere with each other which makes it difficult to unwind the support board when used.

The japanese patent publication H4-92494 discloses an entry sheet for perforation processing which contains on an aluminium substrate a water soluble lubrication layer including a mixture of 20 %wt to 90 %wt of polyethylene glycol having a molecular mass of more than 10,000 and 80%wt to 10%wt of a water soluble lubrication agent. The japanese publication H6-344297 discloses a water soluble lubrication layer including a mixture of 20 to 90 weight % of polyether ester and 80 to 10 weight % of water soluble lubricant.

In recent years, there is a demand for small diameter holes having diameters of 0.3 mm or less. A well-known problem in the art when drilling such small holes and using an aluminium based entry sheet, is that the drill tends to slip sideways on the surface of the entry sheet. This results in a deteriorated positioning accuracy of the perforation processing, frequent drill breakage, and a rough inner circumferential surface of the perforation. Furthermore, the number of PCB's which can be stacked is limited in order to prevent breakage of drills.

Coated entry sheets which mainly comprise thick layers (100 - 250 um) of polyethylene glycol which are applied on an aluminium base by means of a water-based coating, are often used. However, during drying of such polyethylene glycol containing layers, crystallisation of the PEG polymer has been observed leading to cracking of the layer. By reducing the drying temperature and/or adding low boiling solvents like methanol or ethanol, crystallisation of the polymer could be avoided. However, adding such solvents is not only unfavourable from an environmental and economic point of view but creates a risk of explosure during drying. Moreover, PEG based entry sheets are moisture sensitive leading to storage problems in humid conditions.

The present invention was made in view of the technical problems cited above and aims to provide an entry sheet which reduces drill breakage and provides excellent perforation accuracy.

### SUMMARY OF THE INVENTION

It is an object of the present invention to provide an entry sheet for making through-holes in printed circuit boards which lowers the rate of drill breackage and effectively enhances the accuracy of drilling. It is a further object to provide an entry sheet which, during perforation of PCB's, prevents burr formation and formation of twisted lubrication layer components around the drill bits.

This object is realised by the entry sheet defined in claim 1 which comprises an aluminium substrate and a lubricant layer including 70%wt to 92%wt polyvinyl alcohol.

Preferred embodiments of the present invention are described in the dependent claims.

### DETAILED DESCRIPTION OF THE INVENTION

The entry sheet according to the present invention comprises an aluminium substrate which is preferably subjected to a surface treatment. The aluminium substrate is preferably an aluminium alloy of high purity (>99%) such as H18 or H19. High purity aluminium substrates may improve for example the grainability of the substrate. Also, the purity of the aluminium substrate influences the kind of chips or shavings generated at the time of the perforation process.

The surface of the substrate is preferably electrochemically grained and subsequently anodized. The thickness of the aluminium substrate is preferably between 50 and 500 µm, more preferably between 80 and 200 µm and most preferably 100 and 150 µm. The thickness of the aluminium substrate may influence the occurrence of burrs and/or the formation of chips or shavings generated at the time of the perforation process.

The electrochemical graining of the substrate results in small pits uniformly distributed over the surface. By varying the type and/or concentration of the electrolyte and the applied voltage in the graining step, different types of grains can be obtained. According to the present invention, it has been surprisingly found that the topography of the aluminium substrate highly influences the perforation accuracy of through-holes in PCB's. It has been found that entry sheets including aluminium substrates which are electrochemically grained significantly improve the perforation accuracy. The electrolyte solution may comprise CH₃COOH, HCl, HNO₃ and/or H₃PO₄. The graining step is preferably carried out in an electrolyte solution containing HNO₃, more preferably in an electrolyte solution containing HCl. The concentration of CH₃COOH, HCl, HNO₃ and/or H₃PO₄ in the electrolyte solution preferably varies between 1 g/l and 50 g/l; more preferably between 5 g/l and 30 g/l; most preferably between 7 g/l and 20 g/l. The electrolyte solution may contain other chemicals such as surfactants, salts e.g. Al³⁺ or SO₄²⁻ salts, and additives such as benzoic acid derivatives or sulphonic acid derivatives as disclosed in EP 1 826 022. The electrolyte temperature may be at any suitable temperature but is preferably between 25°C to 55°C, more preferably between 30°C to 45°C. The graining may be carried out using a charge density preferably ranging between 80 and 2000 C/dm², more preferably between 100 and 1500 C/dm² and most preferably between 150 and 1250 C/dm² and a current density preferably ranging between 10 A/dm² to 200 A/dm², more preferably from 20 A/dm² to 150 A/dm² and most preferably from 25 A/dm² to 100 A/dm². The substrate may be obtained by applying an asymmetric current density distribution during the graining process i.e. a higher current density (50 to 100 A/dm2) during the first part (2/3 of time) of the graining process and a reduced current density (20 to 25 A/dm2) during the last part (1/3 of time) of the graining. During the electrochemical graining step a so-called smut layer (Al(OH)₃ layer) is built up.

The surface roughness of the substrate obtained after graining, expressed as arithmetical mean center-line roughness Ra (measured with interferometer NT3300 from Veeco) may vary between 0.05 and 1.5 µm. The aluminium substrate of the current invention has preferably an Ra value between 0.1 µm and 1.0 µm, more preferably between 0.20 µm and 0.50 µm, and most preferably between 0.30 µm and 0.45 µm.

The grained aluminium substrate can be etched chemically with an acid or an alkali whereby the smut remaining on the surface may be partially removed; this is also referred to in the art as a desmut step. The partial desmut step is preferably carried out in an aqueous acidic desmut solution and may improve the adhesion between the lubricant layer and the substrate. The desmut step may also prevent the occurrence of corrosion problems. The aqueous acidic desmut solution may comprise for example H₃PO₄ and/or H₂SO₄ at a concentration varying between 10 and 600 g/l, preferably between 20 and 400 g/l, most preferably between 40 and 300 g/l. Besides the chemical composition and the concentration of the desmut solution, also its temperature and reaction time may influence the efficiency of the desmut step. The reaction time preferably varies between 0.5 and 30 s, more preferably between 1 and 25 s and most preferably between 1.5 and 20 s and the temperature varies preferably between 20 and 95°C, more preferably between 25 and 85°C. The desmutting step is usually carried out by dipping or spraying the support with the desmut solution.

It was found that the adhesion between the aluminium substrate and the lubricant layer is highly improved by electrochemically graining, optionally partially desmutting, and anodizing the aluminium. The level of aluminium metal particles which are typically present in the smut layer of the support may influence the adhesion of the lubricant layer on the support. When the level of aluminium metal particles in the smut layer is increased, the adhesion of the lubricant layer may be increased. The level of aluminium metal particles in the smut layer may be increased by applying an electrolyte solution containing a higher level of HCl and/or by reducing the current density at the end of the graining step as described above.

The aluminium substrate is preferably anodized by means of anodizing techniques employing sulphuric acid and/or a sulphuric acid/phosphoric acid mixture. By anodising the aluminium support, its abrasion resistance, corrosion resistance and coatability are are improved. The microstructure as well as the thickness of the Al₂O₃ layer are determined by the anodising step, the anodic weight (g/m² Al₂O₃ formed on the aluminium surface) varies between 0.1 and 8 g/m². The anodic weight of the current invention is preferably between 0.05 g/m² and 5 g/m², more preferably between 0.10 g/m² and 3.0 g/m², even more preferably between 0.15 - 2.5 g/m² and most preferably between 0.15 g/m² and 0.5 g/m². The Al₂O₃ layer is formed beneath the remaining smut layer. Methods of anodizing are known in the art and are for example disclosed in GB 2,088,901.

An electrochemically grained and anodised aluminium substrate with a specification for roughness between 0.30 - 0.45 um and an anodic weight thickness between 0.15 - 0.5 g/m² is preferred.

The grained and anodized aluminium support may be subject to a so-called post-anodic treatment. For example, the aluminium support may be silicated by treating its surface with a solution including one or more alkali metal silicate compound(s) - such as for example a solution including an alkali metal phosphosilicate, orthosilicate, metasilicate, hydrosilicate, polysilicate or pyrosilicate - at elevated temperature, e.g. 95°C. Alternatively, a phosphate treatment may be applied which involves treating the aluminium oxide surface with a phosphate solution that may further contain an inorganic fluoride. Further, the aluminium oxide surface may be rinsed with a citric acid or citrate solution, gluconic acid, or tartaric acid. This treatment may be carried out at room temperature or may be carried out at a slightly elevated temperature of about 30 to 50°C. A further interesting treatment involves rinsing the aluminium oxide surface with a bicarbonate solution. Still further, the aluminium oxide surface may be treated with polyvinylphosphonic acid, polyvinylmethylphosphonic acid, phosphoric acid esters of polyvinyl alcohol, polyvinylsulphonic acid, polyvinylbenzenesulphonic acid, sulphuric acid esters of polyvinyl alcohol, acetals of polyvinyl alcohols formed by reaction with a sulphonated aliphatic aldehyde, polyacrylic acid or derivates such as GLASCOL E15^{™} commercially available from Ciba Speciality Chemicals. One or more of these post-treatments may be carried out alone or in combination. More detailed descriptions of these treatments are given in GB-A 1 084 070, DE-A 4 423 140, DE-A 4 417 907, EP-A 659 909, EP-A 537 633, DE-A 4 001 466, EP-A 292 801, EP-A 291 760 and US 4,458,005.

The entry sheet of the present invention is provided with one or more layer(s). A layer including a water soluble resin is preferred. The layer including such a resin is further referred to as "the lubricant layer".

The lubricant layer comprises 70%wt to 92%wt of polyvinyl alcohol (PVA); more preferably 75 to 90%wt, even more preferably 75 to 85%wt; and most preferably 80 to 85%wt; relative to the coating as a whole. The polyvinylalcohol preferably has a hydrolysis degree ranging between 65 mol % and 99 mol %. The weight average molecular weight of the polyvinylalcohol can be measured indirectly by measuring the viscosity of an aqueous solution of the polyvinyl alcohol at a concentration of 4 % by weight, at 20°C as defined in DIN 53 015. The measured viscosity number ranges preferably between 3 and 26, more preferably between 3 and 15, most preferably between 3 and 10.

The lubricant layer preferably further contains at least one lubricant. The lubricant layer preferably contains 8%wt to 30%wt of a lubricant, more preferably 5%wt to 25 %wt, and most prefarably 4%wt to 20 %wt, relative to the coating as a whole. The at least one lubricant is preferably polyethylene glycol (PEG). The polyethylene glycol preferably has an average molecular weight between 500 and 30000, more preferably between 800 and 25000, and most preferably between 1000 and 20000. Above a MW of 30000, the polyethylene glycols tend to phase separate in the coating solution. The layer may contain a mixture of 2 or more PEG's of different molecular weight.

The PCB may be washed after usage by means of a suitable washing liquid. The washing liquid can be applied to the plate e.g. by rubbing with an impregnated pad, by dipping, immersing, (spin-) coating, spraying, pouring-on, either by hand or in an automatic washing apparatus. The treatment with a washing liquid may be combined with mechanical rubbing, e.g. by a rotating brush. Suitable washing liquids are plain water or an aqueous solution. By improving the water-solubility of the lubricant layer, the dissolution and/or removal of the residuals of the lubricant layer present on the PCB after the perforation process can be improved. The water-solubility of the lubricant layer can be improved by adding one or more additional water-soluble resin(s). Suitable water-soluble resins may be selected from polyoxyethylene, polyoxyethylene propylene copolymer, polyoxyethylene sorbitan laurate, polyethylene glycol lauryl ether, polyvinylpyrrolidone, polyethylene glycol nonyl ether, castor oil polyethylene glycol ether, polyethylene glycol octyl ether, polyoxyethylene ether, or gelatine and/or derivatives thereof.

The lubricant layer may contain additional ingredients such as glycerol, organic or inorganic fillers and solvents. Inorganic fillers may include silicon dioxide, aluminium hydroxide, aluminium oxide, titanium dioxide or calcium carbonate. Suitable solvents may be water, methanol, ethanol, acetone and/or mixture thereof. Examples of the organic filler include powders such as cellulose powder or fine particles of a thermosetting resin and a thermoplastic resin such as a phenol resin, a melamine resin, an epoxy resin, a silicone resin, a (meth)acrylic resin, a polyurethane resin, a polycarbonate resin, a polyphenylene ether resin or a polyester resin. The average particle diameter of the organic filler is 50 µm or less, preferably approximately from 1 to 10 µm. The organic filler is added in an amount of from 1 to 50 %wt, preferably from 5 to 30 %wt, relative to the coating as a whole.

The entry sheet may include besides the lubricant layer other layers such as for example a layer that further improves adhesion between the lubricant layer and the substrate.

The lubricant layer may be applied on the aluminium substrate by roller coating, spin coating or film coating of an aqueous solution. The aqueous coating solution preferably has a concentration of 5 to 25 %wt; more preferably a concentration of 10 to 20 %wt and most preferably a concentration between 12 and 18 %wt.

The lubricant layer preferably has a thickness of 10 to 150 µm, more preferably a thickness between 15 to 100 µm and most preferably between 20 and 50 µm.

According to the present invention, a method for making an entry sheet is also provided. The lubricant layer is applied onto the aluminium substrate by means of coating an aqueous solution. Subsequently, the entry sheet is dried. Two or more coating solutions may be applied to the substrate. The multi-layer coating can be applied by coating/drying each layer consecutively or by the simultaneous coating of several coating solutions at once. The plate can be dried by for example heating at a temperature which is higher than the glass transition temperature of the PVA. The drying period is preferably more than 15 seconds, more preferably more than 20 seconds and most preferably the drying period is less than 2 minutes. A preferred drying temperature is above 60 °C, more preferably above 100°C. Drying can be done in conventional hot air ovens or by irradiation with lamps emitting in the infrared or ultraviolet spectrum. In the drying step, the volatile solvents are removed from the coating until the coating is self-supporting and dry to the touch. However it is not necessary (and may not even be possible) to remove all the solvent in the drying step. Indeed the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

The coating quality and stability in humid conditions as well as in hot storage conditions of the lubricant layer of the present invention, even for thick wet layer coatings up to 200 um, is excellent. To further improve the coatability, one or more lubricant(s) may be added to the lubricant layer.

According to the present invention, there is also provided a method for perforation processing wherein the entry sheet as described above is disposed on top of a plurality of stacked printed circuit boards and a perforation preferably having a diameter of 0.3 mm or less is formed in the entry sheet and the printed circuit boards.

### EXAMPLES

While the present invention will hereinafter be described in connection with preferred embodiments thereof, it will be understood that it is not intended to limit the invention to those embodiments. Unless otherwise specified, all compounds and solvents used in the Examples are readily available from fine chemical suppliers such as Acros or Aldrich.

### Preparation of the aluminium substrate

A 0.15 mm thick aluminum foil was degreased by dipping in an aqueous solution containing 34 g/l NaOH at 75°C for 5 seconds and rinsed with demineralised water for 5 seconds followed by a rinsing with a diluted HCl solution with a conductivity of 100 mS. The foil was then electrochemically grained using an alternating current (50 Hz) in an aqueous solution containing 15 g/l HCl, 15 g/l of SO₄²⁻ present as Al2(SO4)3 and extra AlCl3 in order to have a total Al³⁺ content of 6 g/l at a temperature of 37°C and a current density of 80 A/dm² and a total charge density of 600 C/dm². Afterwards, the aluminum foil was rinsed with demineralised water and partially desmutted by etching with an aqueous solution containing 5 g/l of NaOH at 35°C for 5 seconds and rinsed with demineralised water for 5 seconds. The foil was subsequently subjected to anodic oxidation in an aqueous solution containing 145 g/l of sulphuric acid at a temperature of 57°C and a current density of 2 A/dm² (charge density of 35 C/dm²), then washed with demineralised water.

The substrate thus obtained is characterised by a surface roughness Ra of 0.35 - 0.42 µm (measured with an interferometer NT3300 from Veeco) and an anodic weight of about 0.3 g/m².

### Ra measurement using the interferometer NT3300

### Roughness scan parameter settings:

| | |
|---|---|
| Magnification: | 20x |
| Field of View lens: | 0.5x |
| Field of view: | 596 *µ*m x 453 *µ*m |
| Array size: | 736 x 480 |
| Spatial Sampling: | 811.11 nm |
| Optical Resolution: | 0.75 *µ*m |
| Modulation Treshhold: | 0.5% |

### Processed options:

| | |
|---|---|
| Terms removal: | cylinder and tilt |
| Filtering: | Median (window size = 3) |
| Data Restore: | Restore interior and exterior points (data restore pixels = 15) |

### Anodic weight measurement

The determination of the anodic weight is performed by comparing the weight of the substrate before and after dipping in a sodium molybdate - phosphoric acid solution (gravimetric determination). The substrate needs to be dipped for 10 min in a water based solution containing 25 g/l of sodium molybdate and 75 g/l of phosphoric acid. In order to obtain a complete dissolution, the water based solution is heated up to 80°C. After dissolution of the oxide layer the substrate needs to be rinsed with water and dried properly prior to weighing.

An uncoated grained and anodized aluminium support (as described above) was used as reference entry sheet: ES-ref.

### Preparation of the entry sheets ES-01 to ES-05

The coating solutions (at a solid concentration of 15%wt in water) CS-01 to CS-05 were coated on the aluminium substrate as described above, with a coating knife at a wet thickness of 200 µm. After drying in an oven at a temperature of about 110°C for 5 minutes, the entry sheets ES-01 to ES-05 were obtained.

Table 1 provides the composition of the coating solutions CS-01 to CS-05 used in the preparation of the entry sheets including PVA and different ratio's of PVA and PEG. For obtaining a clear solution, the ingredients were heated for several hours in water up to a temperature of 95°C.

To improve the coating quality, the surfactant Lutensol A8, commercially available from BASF, was added in a concentration of 0.23% of the total dry weight.

**Table 1: Entry sheets including different ratio's PVA/PEG.**

| Coating solutions | Entry sheet | Composition (ratio W/W %) | | Type of PEG (MW) |
|---|---|---|---|---|
| | | PVA (1) | PEG (2) | |
| CS-01, *comparative* | ES-01, *comparative* | 100 | 0 | - |
| CS-02, *inventive* | ES-02, *inventive* | 90 | 10 | 1,000 |
| CS-03, *inventive* | ES-03, *inventive* | 80 | 20 | 1,000 |
| CS-04, *inventive* | ES-04, *inventive* | 70 | 30 | 1,000 |
| CS-05, *comparative* | ES-05, *comparative* | 65 | 35 | 1,000 |

| | | | | |
|---|---|---|---|---|
| (1) Polyvinyl alcohol: Mowiol 4-88 commercially available from Kuraray; (2) Polyethylene glycol: PEG 1000 commercially available from Acros Chimica. | | | | |

### Perforation test

The coated entry sheet was placed on top of a test PCB : Hitachi MLC-679FG(S)^{™} commercially available from Hitachi Chemical Co. America, Ltd.. The test PCB typically has a thickness of approximately 500 µm and comprises a layered composition including glass fibre material provided at both sides with a copper layer having a thickness of 18 µm and in the middle an approximately 200 µm thick layer of FR4 - i.e. a composite material including woven fiberglass cloth and a flame retardant epoxy. Each entry sheet/test PCB panel was drilled using a Schmoll MX1^{™} drilling machine, available from Shmoll Maschinen GmbH., the panel size used was 303 x 223 cm². On each pannel 4 different drill arreas were defined and in each area 5000 drills were performed. These 5000 drills were all performed with the same drill bit and this drill bit was changed when a new area was drilled.

The drill bit used had a diameter of 100 µm and the drilling was performed with a rotation speed of 250K rpm. The number of drill bits that broke off during the four drill series (5000 drills in each area) was counted and the results are listed in the table below in the column "drill breakage".

The bore hole accuracy was assesed via an Impex Pro X3^{™} Modular Measuring Machine commercially available form IMPEX. Misregistration between a reference value of a hole location and the location of the hole on the top of the PCB after drilling was assessed. Drilling accuracy was evaluated by studying the standard deviation over the first 1000 drills with a 100 µm drill bit in the X and Y direction. The lower the standard deviaton in X and Y direction, the better the performance of the entry sheet towards drill position accuracy. The standard deviations for the different entry sheets are listed in the table 2 below.

### Results of the perforation test

The results of the perforation test are summarized in Table 2.

**Table 2: results of perforation test.**

| Entry Sheets | Drill breakage (1) 100 *µ*m drill | Perforation accuracy expressed as standard deviation in X direction (in mm)(3) | Perforation accuracy expressed as standard deviation in Y direction (in mm)(3) |
|---|---|---|---|
| ES-ref, *reference* | 0 | 0.0055 | 0.0056 |
| ES-01, *comparative* | 4 | 0.0036 | 0.0035 |
| ES-02, *Inventive* | 0 | 0.0032 | 0.0023 |
| ES-03, *Inventive* | 1 | 0.0037 | 0.0021 |
| ES-04, *Inventive* | 0 | 0.0035 | 0.0026 |
| ES-05, *comparative* | (2) | (2) | (2) |

| | | | |
|---|---|---|---|
| (1) amount of drill bits (out of 4) which broke during the four perforation processes each counting 5000 hits; (2) not analysable due to a too poor coating quality. (3) a standard deviation in X or Y direction below 0.0040 mm relates to a good perforation accuracy. | | | |

The results in Table 2 show that:
▪ the entry sheets including a lubricant layer including 90%wt to 70%wt of poylvinyl alcohol (ES-02 to ES-04) all provide improved results compared to the comparative entry sheet including a lubricant layer including 100%wt poylvinyl alcohol (ES-01) in terms of drill breakage;
▪ furthermore, the entry sheets including a lubricant layer including 70%wt or more of poylvinyl alcohol (ES-01 to ES-04) provide a significant improvement in perforation accuracy of the drill hole in comparison to the non-coated reference ES-ref;
▪ for the entry sheet ES-05 including 65%wt of polyvinyl alcohol unacceptable coating cosmetics are obtained (complete phase separation between the PVA and PEG layer) and as a consequence its performance in drilling could not be assessed.

### Preparation of the entry sheets ES-06 to ES-10

The coating solutions (at a solid concentration of 15%wt in water) CS-06 to CS-10 were coated on the aluminium substrate as described above, with a coating knife at a wet thickness of 200 µm. After drying on a plate at 35°C for 5 minutes, the entry sheets ES-06 to ES-10 were obtained.

In order to obtain clear solutions for the different products in water, the ingredients were heated for several hours in water to a temperature up to 95°C.

To improve the coating quality, the surfactant Lutensol A8, commercially available from BASF, was added in a concentration of 0.23% of the total dry weight.

Table 3 provides the composition of the coating solutions CS-06 to CS-10 used in the preparation of the entry sheets including different MW of PEG.

**Table 3: Entry sheets including different MW of PEG.**

| Coating solutions | Entry sheet | Composition (ratio W/W %) | | Type of PEG (MW) (1) |
|---|---|---|---|---|
| CS-06, *comparative* | ES-06, *comparative* | 90 | 10 | 400 |
| CS-07, *inventive* | ES-07, *Inventive* | 90 | 10 | 1,000 |
| CS-08, *inventive* | ES-08, *inventive* | 90 | 10 | 3,000 |
| CS-09, *inventive* | ES-09, *inventive* | 90 | 10 | 10,000 |
| CS-10, *inventive* | ES-10, *inventive* | 90 | 10 | 20,000 |

| | | | | |
|---|---|---|---|---|
| (1) Polyethylene glycol: PEG 400 commercially available from Hoecht; PEG 1000 commercially available from Acros Chimica; PEG 3000, PEG 1000 and PEG 20000 commercially available from Aldrich; | | | | |

### Perforation test

The test as described above was carried out using the entry sheets ES-06 to ES-10.

### Results of the perforation test

The results of the perforation test are summarized in Table 4.

**Table 4: results of the perforation test.**

| Entry Sheets | Drill breakage (1) (100 µm drill) | Perforation accuracy expressed as standard deviation in X direction (in mm)(2) | Perforation accuracy expressed as standard deviation in Y direction (in mm) (2) |
|---|---|---|---|
| ES-ref, *reference* | 0 | 0.0055 | 0.0056 |
| ES-06, *comparative* | 4 | 0.0036 | 0.0018 |
| ES-07, *inventive* | 0 | 0.0032 | 0.0023 |
| ES-08, *inventive* | 0 | 0.0031 | 0.0029 |
| ES-09, *inventive* | 0 | 0.0023 | 0.0029 |
| ES-10, *inventive* | 1 | 0.0030 | 0.0028 |

| | | | |
|---|---|---|---|
| (1) amount of drills (out of 4) which broke during the perforation process of 5000 hits; (2) a standard deviation in X and Y direction below 0.0040 mm relates to a good perforation accuracy. | | | |

The results in Table 4 show that:
▪ the entry sheets including a lubricant layer including 90%wt of poylvinyl alcohol and 10%wt of polyethylene glycol all provide improved results in terms perforation accuracy compared to the reference entry sheet;
▪ the entry sheet ES-06 including polyethylene glycol having a molecular weight of 400 shows an unacceptable level of drill breakage.

## Claims

1. An entry sheet for perforation processing comprising an aluminium substrate and a lubricant layer,
**characterised in that** the lubricant layer includes 70%wt to 92%wt polyvinyl alcohol.

2. An entry sheet according to claim 1 wherein the lubricant layer further comprises at least one lubricant.

3. An entry sheet according to claims 1 or 2 wherein the at least one lubricant is present in an amount of 8%wt to 30%wt.

4. An entry sheet according to claims 1 or 2 wherein the at least one lubricant is present in an amount of 5%wt to 25%wt.

5. An entry sheet according to any of the preceding claims wherein the at least one lubricant is selected from one or more polyethylene glycol(s).

6. An entry sheet according to claim 5 wherein the polyethylene glycol(s) have a molecular weight of 800 to 25000.

7. An entry sheet according to any of the preceding claims wherein the lubricant layer comprises 75%wt to 85%wt polyvinyl alcohol.

8. An entry sheet according to any of the preceding claims wherein the aluminium substrate is electrochemically grained.

9. An entry sheet according to claim 8 wherein the graining step is carried out in an aqueous solution comprising HCl and/or CH₃COOH.

10. An entry sheet according to claims 8 or 9 wherein after graining a desmutting step is carried out by contacting the support with an aqueous acidic solution for a period ranging between 1 and 15 s.

11. An entry sheet according to claims 8 to 10 wherein an anodizing step is carried.

12. An entry sheet according to any of the preceding claims wherein the substrate has a surface roughness, expressed as arithmetical mean center-line roughness Ra, ranging between 0.30 - 0.45 µm.

13. An entry sheet according to any preceding claim wherein the aluminium substrate comprises between 0.05 g/m² and 0.5 g/m² of aluminium oxide at the hydrophilic surface.

14. A method for making an entry sheet comprising an aluminium substrate including the steps of:
(i) coating on said substrate an aqueous composition comprising polyvinyl alcohol;
(ii) drying said coated composition;
**characterized in that** the dried composition includes 70 to 92%wt polyvinyl alcohol.

15. A method according to claim 14 wherein the dried composition includes 75%wt to 85%wt polyvinyl alcohol.
